# EUROPEAN PATENT SPECIFICATION

(11) **EP 0 616 471 B1**
(45) Date of publication and mention of the grant of the patent: **06.09.2000**
(21) Application number: 94301961.2
(22) Date of filing: 18.03.1994
(51) Int. Cl.: H04N 7/30

(54) **Coding of digital signals**
Kodierung von digitalen Signalen
Codage de signaux numériques

(30) Priority: 19.03.1993 JP 6028693
(43) Date of publication of application: 21.09.1994
(73) Proprietor: SONY CORPORATION, Tokyo (JP)
(72) Inventor: Segawa,Yoshihisa c/o Intellec.Prop.Div., / (JP); Kitamura,Takuya Intellec. Prop. Div., Shinagawa-ku Tokyo 141 (JP); Murakami,Yoshihiro Intellec.Prop.Div., Shinagawa-ku Tokyo 141 (JP)
(74) Representative: Williams, Janice

(56) References cited:
- EP-A- 0 439 624
- US-A- 4 626 829
- US-A- 4 908 862
- US-A- 4 953 020
- COMMUNICATIONS OF THE ASSOCIATION FOR COMPUTING MACHINERY, vol.34, no.4, April 1991, NEW YORK US pages 31 - 44 WALLACE 'the JPEG still picture compression standard'

## Description

The invention relates generally to coding of digital signals and provides coding apparatus for use for example with apparatus for transmitting or recording and reproducing a variety of information, such as video and audio signals or the like.

A variety of video signal coding apparatus have hitherto been proposed to transmit or record an image at a bit rate as low as possible with a sufficiently high picture quality.

As one of such coding apparatus, there has been proposed a high-efficiency coding apparatus using a DCT (discrete cosine transform) and a Huffman coding.

In this coding apparatus, data such as video and audio data to be coded is converted into coefficient data by a discrete cosine transform (DCT) circuit, for example, at every block from a DC component to a high-order AC component. The coefficient data is then quantized and the coefficient data thus quantized is coded by a variable length coder.

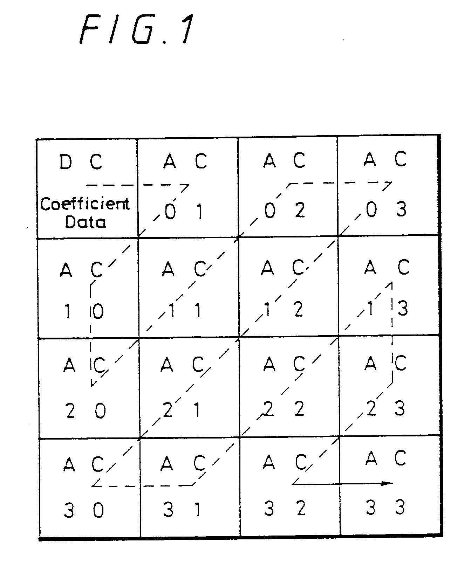

The DCT circuit converts a DC component to a high-order AC component of the blocked data into two-dimensional coefficient data. Converted coefficient data is scanned (in a so-called zigzag scan fashion) and then coded, as shown in FIG. 1. Coding is carried out in accordance with the scanning order, and coefficient data of the last coefficient which becomes non-zero after quantization lies in a coding range.

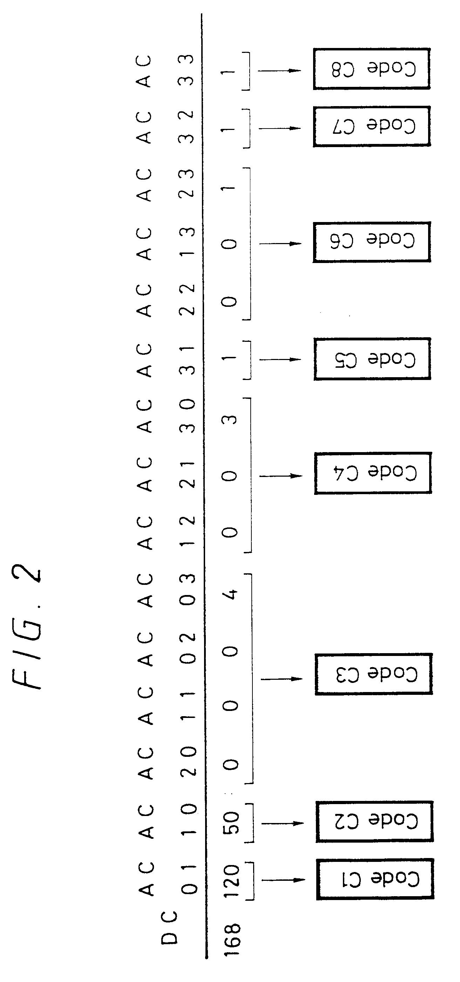

Coefficient data obtained within the coding range by the zigzag scanning are arrayed in a line as shown in FIG. 2, for example. The coefficient data thus arrayed are coded by the variable length coder according to some suitable methods, such as the Huffman coding method or the like. U.S. patent No. 4,901,075 describes the Huffman coding technique.

In FIG. 2, DC represents DC component coefficient data ("168" in this example shown in FIG. 2), and AC01 through AC33 represent AC component coefficient data. The AC component coefficient data becomes high-order as their numerals become large. As shown in FIG. 2, the DC component coefficient data DC to the high-order AC component coefficient data AC33 are coded as codes C1 to Cn, in that order. Also, as shown in FIG. 2, when coefficient data are coded, they are coded at the unit of consecutive "0"s and the succeeding value. In the following description, "0 run" means the number of consecutive "0"s. Expression of "0 run 0" shows that the number of "0 run" is "0", i.e., there exists no "0".

In FIG. 2, AC component coefficient data AC20 is "0", the next AC component coefficient data AC11 is "0", the next AC component coefficient data AC02 is "0" and the next AC component coefficient data AC03 is "4", which therefore will be referred to as "0 run 3, value 4". AC component coefficient AC01 is "120" and therefore will be referred to as "0 run 0, value 120".

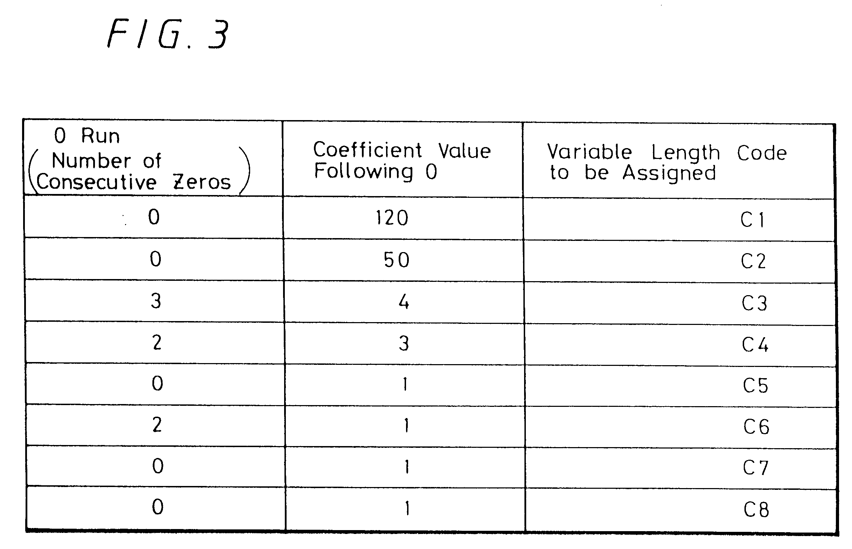

How to code the coefficient data shown in FIG. 2 will be described below with reference to FIG. 3. FIG. 3 is a table to which reference will be made in assigning codes in response to 0 run and values following the last "0". To understand the system more clearly, FIG. 3 illustrates only values of 0 run and succeeding coefficient values. The table shown in FIG. 3 is made in accordance with the previously proposed Huffman code forming procedure.

AC component coefficient data AC01 is "120" as shown in FIG. 2, and described as "0 run 0, coefficient value 120" as shown in FIG. 3. Therefore, a variable length code to be assigned thereto becomes a code C1, for example. AC component coefficient data AC10 is "50" as shown in FIG. 2, and described as "0 run 0, coefficient value 50". Therefore, a variable length code to be assigned thereto becomes a code C2 as shown in FIG. 3.

The next AC component coefficient data AC20 is "0", the succeeding AC component coefficient data AC11 is "0", the succeeding AC component coefficient data AC02 is "0" and the succeeding AC component data AC03 is "4", i.e., three consecutive "0"s are followed by "4" which is non-zero. In this case, as shown in FIG. 3, "0 run 3, coefficient value 4" is established and a variable length code to be assigned thereto becomes a code C3. Similarly, AC component coefficient data AC12 is "0", the succeeding AC component coefficient data AC21 is "0", and the succeeding AC component coefficient data AC30 is "3". In this case, as shown in FIG. 3, "0 run 2, coefficient value 3" is established and therefore a variable length code to be assigned thereto becomes a code C4.

Subsequently, AC component coefficient data AC31 is "1" and "0 run 0, coefficient value 1" is established as shown in FIG. 3. Thus, a variable length code to be assigned thereto becomes a code C5. Then, AC component coefficient data AC22 is "0", the succeeding AC component coefficient data AC13 is "0" and the succeeding AC component coefficient data AC23 is "1". In this case, as shown in FIG. 3, "0 run 2, coefficient value 1" is established and a variable length code to be assigned thereto becomes a code C6 accordingly. AC component coefficient data AC32 is "1" and "0 run 0, coefficient value 1" is established and a variable length code to be assigned thereto becomes a code C7 accordingly. Similarly, AC component coefficient data AC33 is "1" and "0 run 0, coefficient value 1" is established as shown in FIG. 3 with the result that a variable length code to be assigned thereto becomes a code C8.

As described above, in the previously proposed coding apparatus, the coding range of coefficient data is determined by scanning the DC component to the high-order AC component of the coefficient data obtained by the DCT in a zigzag scanning fashion. Coefficient data which fall in the coding range are arrayed in a line in the order of zigzag scanning. Then, the coefficient data thus arrayed are coded on the basis of the table made in accordance with the Huffman code forming procedure, i.e., table formed of the number of consecutive "0"s and codes corresponding to the following values of non-zeros.

The assignee of the present application has previously proposed data transmission apparatus (see U.S. Patent No. 5,006,931) which will be described below.

According to the previously-proposed data transmission apparatus, a two-dimensional image block formed of (n x n) pixels is coded by some suitable code conversion method, such as a cosine transform or the like. DC component thus obtained by the coding is transmitted in a predetermined bit number. The (n square - 1) AC components are divided into (m x m) (n > m) sub blocks and address information of sub block having purposive data and purposive coefficient data within the sub block to be transmitted are transmitted at the unit of sub block, whereby a transmission data amount can be made smaller than a predetermined target value under feedforward control.

Furthermore, according to the previously-proposed data transmission apparatus, a two-dimensional image block formed of (n x n) pixels is coded by some suitable code conversion method, such as a cosine transform or the like. DC component thus obtained by the coding is transmitted in a predetermined bit number. A frequency at which (n square - 1) AC components occur at the unit period, such as one field, one frame or the like, is detected. Then, the degree of occurrence is converted into accumulative distribution data, and an amount of data generated during the unit period is controlled so as to become smaller than a target transmission data amount on the basis of the accumulative frequency distribution data (see U.S. Patent No. 5,006,931).

As described above, in the conversion coding, such as a DCT or the like, coefficient data from low-order coefficient data to high-order coefficient data within the block are scanned in a zigzag fashion and consecutive "0"s and other numbers than "0" are formed as a group to which codes that are uniquely determined are assigned. Also in the subband coding, it is customary that codes which are uniquely determined are assigned to a group of consecutive "0"s within the band or between the bands and consecutive coefficients.

According to the aforesaid methods, when "0"s are continued, the efficient coding becomes possible. However, when "0"s are not continuous, the efficient coding becomes impossible.

United States Patent US-A-4,626,829 discloses a system for compressing character data using run length coding followed by statistical coding using a coding table selected in dependence upon the degree of compression achieved for the previous symbol or whether the previous symbol was one of a subset of number symbols.

Various aspects of the present invention are set out in the accompanying claims.

Embodiments of the present invention provide a coding apparatus having a high compression ratio.

Further embodiments of the present invention provide a coding apparatus in which a coding table is created in response to example condition series.

Embodiments of the invention will now be described, by way of example, with reference to the accompanying drawings in which:
FIG. 1 is a diagram used to explain a previously proposed coding system and illustrating an example of a discrete cosine transform scanning method;
FIG. 2 is a diagram used to explain a previously proposed coding system, i.e., how to determine a code on the basis of consecutive "0"s and a coefficient value following the last "0";
FIG. 3 is a diagram used to explain a previously proposed coding system, i.e., how to code coefficient data;
FIGS. 4A and 4B are schematic block diagrams showing a high-efficiency coding apparatus according to an embodiment of the present invention, respectively;
FIG. 5 is a schematic block diagram of a Huffman table generating apparatus and illustrating a method of generating a coding table according to the embodiment of the present invention;
FIG. 6 is a schematic block diagram of a Huffman coding table generating apparatus and illustrating a method of generating a coding table according to another embodiment of the present invention;
FIG. 7 is a diagram used to explain a coding apparatus according to the embodiment of the present invention, i.e., how to determine codes that are assigned to coefficient data;
FIG. 8 is a diagram used to explain the coding apparatus according to the embodiment of the present invention, i.e., a table corresponding to condition series (zero-run, value);
FIG. 9 is a diagram used to explain the coding apparatus according to the embodiment of the present invention, i.e., an example of how to determine codes on the basis of coefficient data values and condition series;
FIG. 10 is a diagram used to explain a method of generating a coding table according to the embodiment of the present invention, i.e., a table that is used to determine sizes of coefficient data;
FIG. 11 is a flowchart used to explain a method of generating a coding table, i.e., operation for making tables corresponding to condition series;
FIG. 12 is a diagram used to explain a high-efficiency coding apparatus according to the embodiment of the present invention, i.e., a table corresponding to size "0";
FIG. 13 is a diagram used to explain the high-efficiency coding apparatus according to the embodiment of the present invention, i.e., a table corresponding to size "1";
FIG. 14 is a diagram used to explain the high-efficiency coding apparatus according to the embodiment of the present invention, i.e., a table corresponding to size "2";
FIG. 15 is a diagram used to explain the high-efficiency coding apparatus according to the embodiment of the present invention, i.e., a table corresponding to size "3";
FIG. 16 is a diagram used to explain the high-efficiency coding apparatus according to the embodiment of the present invention, i.e., a table corresponding to size "4";
FIG. 17 is a diagram used to explain the high-efficiency coding apparatus according to the embodiment of the present invention, i.e., a table corresponding to size "5";
FIG. 18 is a diagram used to explain the high-efficiency coding apparatus according to the embodiment of the present invention, i.e., a table corresponding to size "6";
FIG. 19 is a diagram used to explain the high-efficiency coding apparatus according to the embodiment of the present invention, i.e., a table corresponding to size "7";
FIG. 20 is a diagram used to explain the high-efficiency coding apparatus according to the embodiment of the present invention, i.e., a table corresponding to size "8";
FIG. 21 is a diagram used to explain the high-efficiency coding apparatus according to the embodiment of the present invention, i.e., a table corresponding to size "9";
FIG. 22 is a diagram used to explain the high-efficiency coding apparatus according to the embodiment of the present invention, i.e., a table corresponding to size "10";
FIG. 23 is a diagram used to explain the high-efficiency coding apparatus according to the embodiment of the present invention, i.e., a table corresponding to size "11";
FIG. 24 is a diagram used to explain the high-efficiency coding apparatus according to the embodiment of the present invention, i.e., a table corresponding to size "12";
FIG. 25 is a diagram used to explain the high-efficiency coding apparatus according to the embodiment of the present invention, i.e., a table corresponding to size "13"; and
FIG. 26 is a diagram used to explain the coding apparatus according to the present invention, i.e., a table used to convert leading coefficient data of an AC component.

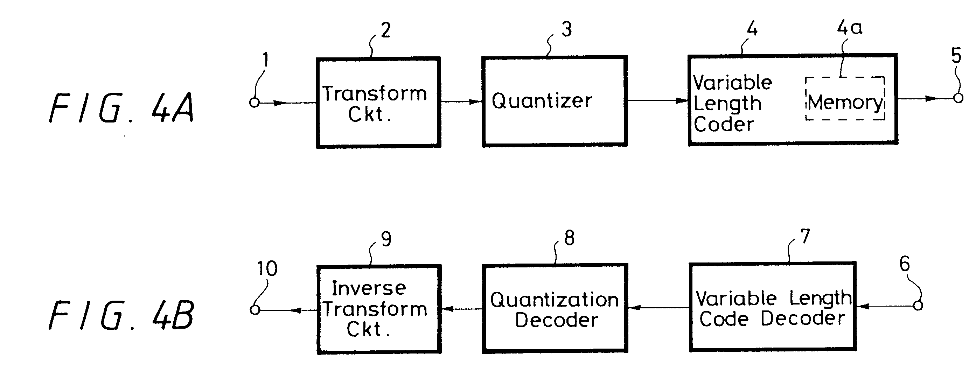

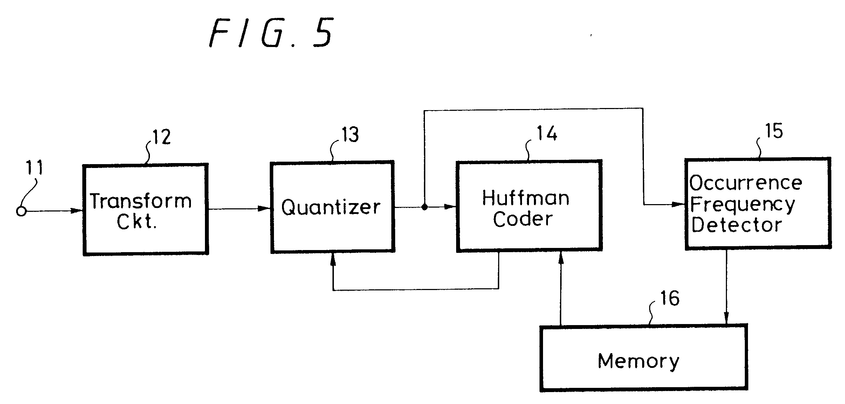

Referring now to the drawings in detail, and initially to FIGS. 4A, 4B and FIG. 5, a coding apparatus according to an embodiment of the present invention will be described below.

A high-efficiency coding apparatus will be described with reference to FIGS. 4A and 4B. FIG. 4A shows an encoder of the high-efficiency coding apparatus and FIG. 4B shows a decoder thereof.

The encoder will be described with reference to FIG. 4A. As shown in FIG. 4A, image data from a body circuit of an electronic equipment, such as a digital video tape recorder (digital VTR) or the like, is supplied to an input terminal 1. The image data applied to the input terminal 1 is supplied to a transform circuit 2.

The transform circuit 2 might be a discrete cosine transform (DCT) circuit, for example. The transform circuit 2 processes the image data supplied thereto from the input terminal 1 by using only a cosine function at every block in a DCT fashion to obtain a DC component to high-order AC components of coefficient data. The orthogonal transform might be a Fourier transform, Hadamard transform, and Karhuen-Loéve transform, for example. The Fourier transform needs calculation of complexes and an arrangement thereof becomes complicated. As other transform systems than the orthogonal transform, there might be considered slant transform and Haar transform. In this embodiment, a high-speed calculation algorithm exists. This high-speed calculation algorithm can be realized by one-chip LSI (large scale integrated circuit) which makes it possible to effect a real time transform of image data. Further, this embodiment uses a DCT which is excellent in electric power concentration of a low frequency component which directly affects the coding efficiency.

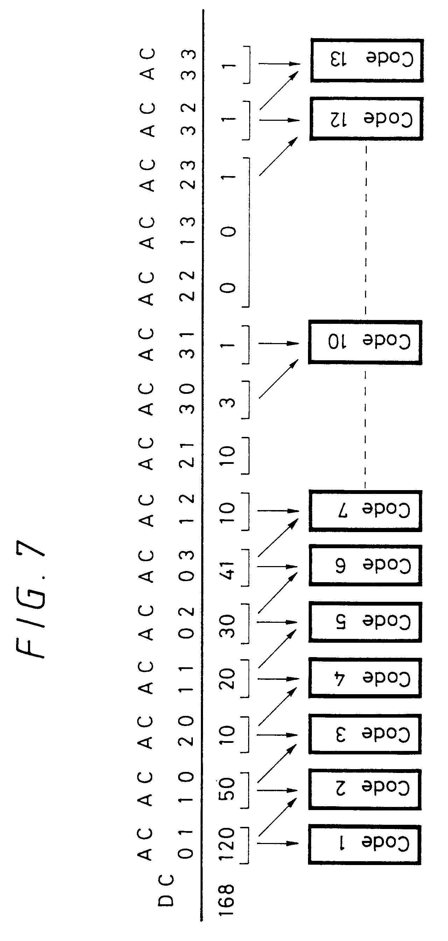

The image data is processed by this transform circuit 2 to be coefficient data, which is supplied to a quantizer 3. The quantizer 3 quantizes the coefficient data supplied thereto from the transform circuit 2. The coefficient data thus quantized is supplied to a variable length coder (VLC) 4. The variable length coder 4 codes the coefficient data supplied thereto from the quantizer 3 by scanning (zigzag scanning) that was earlier noted with reference to FIG. 1. The variable length coder 4 arrays coefficient data provided within the coding range as shown in FIG. 7, and codes the coefficient data thus arrayed in a Huffman coding method.

This embodiment prepares a plurality of tables corresponding to condition series for coding coefficient data thus arrayed. When some coefficient data is coded, a table corresponding to the condition of coefficient data provided before the coefficient data to be coded is selected and the coefficient data is coded on the basis of the table thus selected. In the transform coding, coefficient data that had been converted are correlated with each other. Therefore, if coefficient data is coded by using such a correlation, then the coding efficiency can be improved considerably.

FIG. 5 shows an apparatus for making such table, i.e., a Huffman table generating apparatus to which there is applied a method of generating a coding table embodying the present invention.

As shown in FIG. 5, video signals of the same content are supplied at a predetermined cycle, for example, to an input terminal 11 from the outside. The video signal from the outside is supplied through the input terminal 11 to a transform circuit 12. The transform circuit 12 processes the video signal supplied thereto from the outside through the input terminal 11 in some suitable transform fashions, such as a DCT or the like, and supplies the video signal thus processed to a quantizer 13.

The quantizer 13 quantizes an output from the transform circuit 12, i.e., coefficient data and supplies the coefficient data thus quantized to a Huffman coder 14. The Huffman coder 14 codes the quantized coefficient data from the quantizer 13 in a Huffman coding fashion on the basis of a table stored in a memory 16 and supplies total code length data to the quantizer 13. The total code length data is used to vary a coarseness of quantization. The memory 16 is formed of a read circuit, a write circuit and a memory circuit, such as a DRAM (dynamic random access memory), a SRAM (static random access memory) or the like.

On the other hand, the coefficient data from the quantizer 13 is also supplied to an occurrence frequency detector 15. The occurrence frequency detector 15 detects an occurrence frequency of the coefficient data supplied thereto from the quantizer 13 and generates table data on the basis of detected results so that table data are coded within the total code length according to the Huffman coding manner. The table data thus generated is supplied to the memory 16.

Operation of the Huffman table generating apparatus shown in FIG. 5 will be described below. A video signal that is used to generate table data of a predetermined length, for example, is repeatedly supplied to the input terminal 11. Table data that had been randomly selected are loaded in advance in the memory 16 from the occurrence frequency detector 15 as the initial value.

The quantizer 13 quantizes the video signal used to generate table data of the predetermined length from the input terminal 11 with a coarseness based on the initial control data from the Huffman coder 14. Then, the quantizer 13 supplies the coefficient data thus quantized to the Huffman coder 14 and the occurrence frequency detector 15, respectively. The Huffman coder 14 codes the coefficient data in response to table data loaded in the memory 16 as the initial value.

The occurrence frequency detector 15 detects the occurrence frequency of coefficient data supplied thereto from the quantizer 13 and generates new table data on the basis of detected results so that the new table data may fall within the total code length. Then, the new table data thus generated are loaded onto the memory 16.

To detect the occurrence frequency is to detect the probability at every condition series that a group of 0 run and value occurs. Further, the condition series is "0 run, value (coefficient value)" that was converted just before. Groups of codes on every condition series are made by using the occurrence probability in accordance with the Huffman coding method. This method is known such that symbols (groups of 0 run and value of coefficient data) are arranged in the sequential order of the large occurrence probability, "1" and "0" are arbitrarily assigned to a symbol having the smallest occurrence probability and a symbol having the second smallest occurrence probability and that these two symbols are assumed to be one symbol. Then, the number of symbols is reduced by using the occurrence probability of the combined symbols as a sum of the occurrence probabilities before being combined. This symbol is considered as a new information source and a processing in which symbols are rearranged in the sequential order of large occurrence probabilities is repeated until the symbol becomes "1". When the symbol becomes "1", "1" and "0" that had been initially assigned to the respective symbols are read out in the reverse order. Then, they are used as codes for the symbols.

There is a tendency that, when one of absolute values of the coefficient data within the DCT block is large, absolute values of other coefficient data also are large and that, when one of them is small, absolute values of other coefficient data also are small. Thus, coefficient data are correlated with each other. That is, the frequency with which 0 run and groups of coefficient data values appear changes depending upon the condition series. Therefore, it is possible to suppress the whole code length to be smaller by assigning variable length codes by using this correlation.

When new table data are loaded onto the memory 16, the Huffman coder 14 codes the coefficient data supplied thereto from the quantizer 13 on the basis of the table data, and also supplies the total code length data to the quantizer 13, thereby varying a quantization coarseness in the quantizer 13. Similarly, the Huffman coder 14 codes table forming data of predetermined lengths on the basis of the tables thus changed, and then supplies the total code length data thus obtained by coding to the quantizer 13 so that the quantization coarseness of the quantizer 13 is varied. Then, the new table data are generated by detecting the occurrence frequency, and coefficient data are coded by using the resultant new table data. A number of coding tables corresponding to the above-mentioned condition series are made by repeating a series of the above-mentioned operation.

The table data thus made are stored in a memory 4a of the variable length coder 4 in the encoder of the high-efficiency coding apparatus shown in FIG. 4A. The memory 4a might be formed of an EEPROM (electrically erasable and programmable ROM), a RAM having a backup function, PROM (programmable ROM), a one-time ROM or the like. The table data are stored in the memory 4a according to any one of a method in which table data written by an apparatus which writes data in the memory 4a and the memory 4a in which the table data are stored is mounted on the variable length coder 4 and a method in which the table data are loaded onto the memory 4a of the variable length coder 4 from the Huffman table generating apparatus shown in FIGS. 4A and 4B.

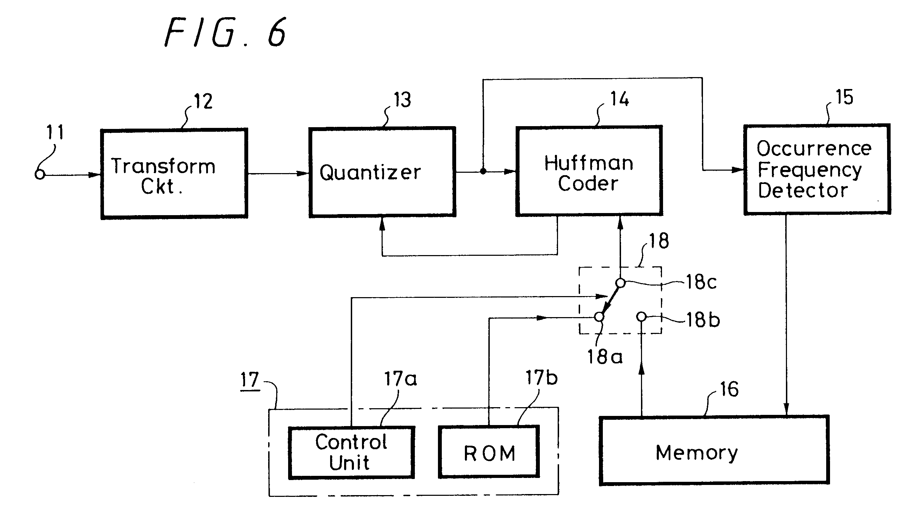

FIG. 6 is a block diagram showing a specific arrangement of the Huffman table generating apparatus shown in FIG. 5. In FIG. 6, like parts corresponding to those of FIG. 5 are marked with the same references and therefore need not be described in detail.

As shown in FIG. 6, there is provided a controller 17 which is comprised of a control unit 17a and a ROM 17b. The table data provided as default values are stored in the ROM 17b of the controller 17. When a power switch is turned on or a reset switch (not shown) is depressed, the control unit 17a supplies a switching control signal to a switch 18 so that the switch 18 connects a movable contact 18c to one fixed contact 18a.

The movable contact 18c of the switch 18 is connected to the input terminal of the Huffman coder 14 and the other fixed contact 18b of the switch 18 is connected to the output terminal of the memory 16. Therefore, when the movable contact 18c of the switch 18 is connected to the fixed contact 18a, the table data provided as the default values stored in the ROM 17b are loaded onto the Huffman coder 14 through the switch 18. When the movable contact 18c of the switch 18 is connected to the fixed contact 18b, the generated table data stored in the memory 16 are loaded onto the Huffman coder 14.

When the power switch of the apparatus is turned on or the reset switch thereof is turned on, the movable contact 18c of the switch 18 is connected to the fixed contact 18a under the control of the control unit 17a of the controller 17, whereby the table data provided as the default values are supplied to the Huffman coder 14 from the ROM 17b. The Huffman coder 14 codes the coefficient data from the quantizer 13 on the basis of the table data supplied thereto and also supplies the total code length data to the quantizer 13 to vary the quantization coarseness in the quantizer 13.

When the new table data are loaded onto the memory 16, the switch 18 connects the movable contact 18c to the fixed contact 18b under the control of the control unit 17a, whereby the new table data from the memory 16 are supplied to the Huffman coder 14. The Huffman coder 14 codes the coefficient data from the quantizer 13 on the basis of the table data supplied thereto and supplies the total code length data to the quantizer 13, thereby varying the quantization coarseness of the quantizer 13. Similarly, table generating data of predetermined length are coded on the basis of the table whose table data are varied. Then, the total code length data obtained by the coding is supplied to the quantizer 13, thereby changing the quantization coarseness of the quantizer 13. New table data are made by detecting the occurrence frequency and then the resultant new table data are coded. Subsequently, a number of coding tables corresponding to the above-mentioned condition series are made by repeating a series of the above-mentioned operation. The table data thus generated are stored in the memory 4a of the variable length coder 4 in the encoder of the high-efficiency coding apparatus shown in FIG. 4A.

As the conditions under which table data are generated as described above can be considered the number of 0 run and values of non-zero. Now, description will be given on the case such that the coefficient data that are arrayed as shown in FIG. 7 are coded on the basis of the table data corresponding to the condition series.

In FIG. 7, reference symbol DC represents a DC component coefficient data and this DC component coefficient data is "168" in this illustrated example. There are provided AC component coefficient data AC01 through AC33. AC component coefficient data become high in order as the numerals affixed thereto are large. As shown in FIG. 7, The DC component coefficient data DC to the high-order AC component coefficient data AC33 are sequentially coded to provide code 1 through code n. As shown in FIG. 7, when the respective coefficient data are coded, coefficient data are coded in response to consecutive "0"s and succeeding values. Similarly to FIG. 1, "0 run" is used as the term which represents the number of consecutive "0"s. Description of "0 run 0", for example, represents that the number of consecutive "0"s is "0", i.e., there is no "0".

As shown in FIG. 7, the AC component coefficient data AC22 is "0", succeeding AC component coefficient data AC13 is "0" and succeeding AC component coefficient data AC23 is "1", which provides "0 run 2, value 1". Also, the AC component coefficient data AC01 is "120" and in this case, "0 run 0, value 120" is established.

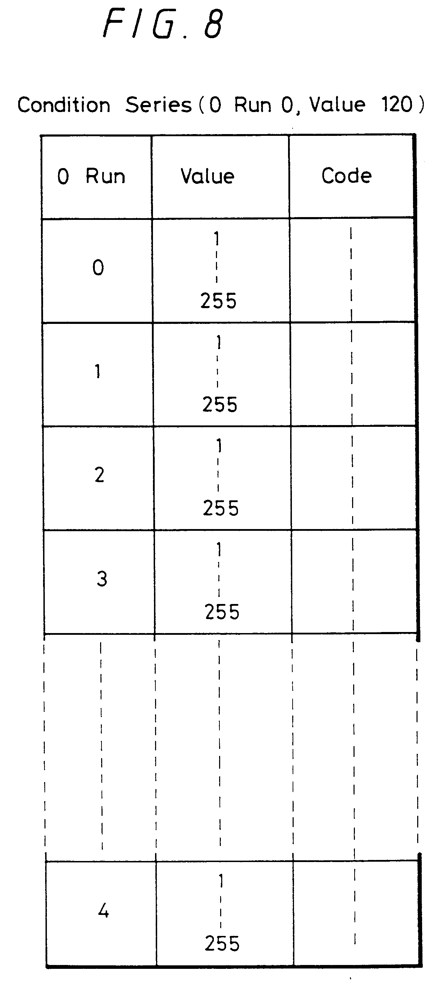

The coding of the coefficient data shown in FIG. 7 will be described with reference to FIG. 8. FIG. 8 shows a table of condition series "0 run 0, value "120". In this table, codes are assigned in response to values of 0 run and values of coefficient data in accordance with the condition series. The present embodiment is different from previous proposals as follows. Initially, a number of tables are made in accordance with the Huffman code making procedure in response to the condition series. When a certain coefficient data is coded, a corresponding table is selected from a number of tables on the basis of the condition of coefficient data provided before the above coefficient data. Then, coefficient data is coded on the basis of the selected table.

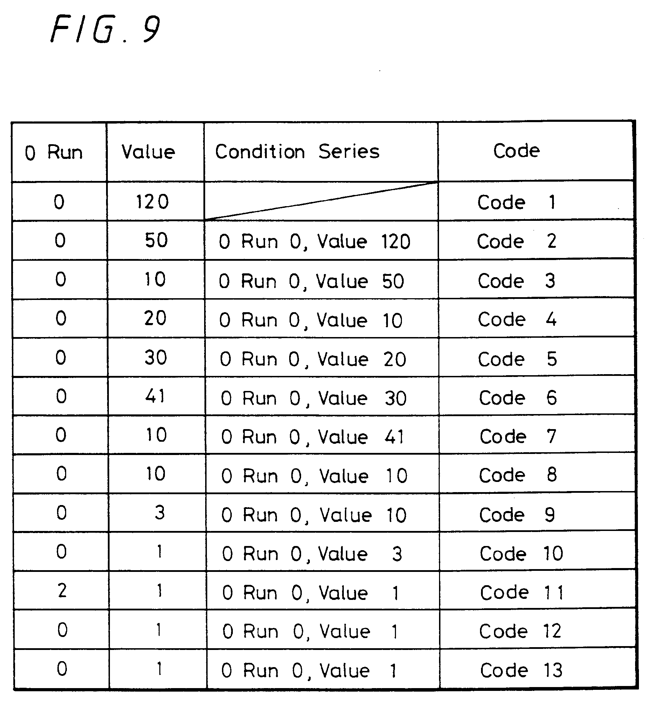

FIG. 9 is a diagram used to explain on the basis of the example shown in FIG. 7 that the table formed on the basis of the condition series described in FIG. 8 is selected by the series of the coefficient data provided before coefficient data to be coded and coefficient data is coded on the basis of the selected table.

As shown in FIGS. 9 and 7, the coefficient data AC01 of the value "120" is provided at the beginning of the AC component and therefore has no condition series. Accordingly, in the coefficient data provided at the beginning of the AC component, the variable length code 1 is obtained from a present value, i.e., the table (table shown in FIG. 3) in which a code is assigned in response to 0 run value and value of coefficient data. This table is the same as the previously proposed one.

The AC component coefficient data AC10 is "50", and the AC component coefficient data provided before the AC component coefficient data AC10 is AC01. The value of the AC component AC01 is "0 run 0 and coefficient value 120". Therefore, a table corresponding to this condition series is selected from a plurality of tables and a variable length code 2 is assigned to a value "50" of the coefficient data AC10 on the basis of the selected table.

The next AC component coefficient data AC20 is "10" and the AC component coefficient data provided before the AC component data AC20 is AC10. The value of the AC component coefficient data AC10 is "0 run 0 and coefficient value 50". Therefore, a table corresponding to this condition series is selected from a plurality of tables and a variable length code 3 is assigned to a value "10" of the AC component coefficient data AC20 on the basis of the selected table.

The next AC component coefficient data AC11 is "20" and the AC component coefficient data provided before the AC component coefficient data AC11 is AC20. The value of the AC component coefficient data AC20 is "0 run 0 and coefficient value 10". Therefore, a table corresponding to this condition series is selected from a plurality of tables and a variable length code 4 is assigned to a value "20" of the AC component coefficient data AC11 on the basis of the selected table.

The next AC component coefficient data AC02 is "30" and the AC component coefficient data provided before the AC02 is AC11. The value of the AC component coefficient data AC11 is "0 run 0 and coefficient value 20". Therefore, a table corresponding to this condition series is selected from a plurality of tables and a variable length code 5 is assigned to a value "30" of the AC component coefficient data AC02 on the basis of the selected table.

The next AC component coefficient data AC03 is "41" and the AC component coefficient data provided before the AC component coefficient data AC03 is AC02. The value of the AC component coefficient data AC02 is "0 run 0 and coefficient value 30". Therefore, a table corresponding to this condition series is selected from a plurality of tables and a variable length code 6 is assigned to a value "41" of the AC component coefficient data AC03 on the basis of the selected table.

The next AC component coefficient data AC12 is "10" and the AC component coefficient data provided before the AC component coefficient data AC12 is AC03. The value of the AC component coefficient data AC03 is "0 run 0 and value 41". Therefore, a table corresponding to this condition series is selected from a plurality of tables and a variable length code 7 is assigned to a value "10" of the AC component coefficient data AC12 on the basis of the selected table.

The next AC component coefficient data AC21 is "10" and the AC component coefficient data provided before the AC component coefficient data AC21 is AC12. The value of the AC component coefficient data AC12 is "0 run 0 and value 10". Therefore, a table corresponding to this condition series is selected from a plurality of tables and a variable length code 8 is assigned to a value "10" of the AC component coefficient data AC21 on the basis of the selected table.

The next AC component coefficient data AC30 is "3" and the AC component coefficient data provided before the AC component coefficient data AC30 is AC21. The value of the AC component coefficient data AC21 is "0 run 0 and value 10". Therefore, a table corresponding to this condition series is selected from a plurality of tables and a variable length code 9 is assigned to a value "3" of the AC component coefficient data AC30 on the basis of the selected table.

The next AC component coefficient data AC31 is "1" and the AC component coefficient data provided before the AC component coefficient data AC31 is AC30. The value of the AC component coefficient data AC30 is "0 run 0 and value 3". Therefore, a table corresponding to this condition series is selected from a plurality of tables and a variable length code 10 is assigned to a value "1" of the AC component coefficient data AC31 on the basis of the selected table.

The AC component coefficient data AC22 is "0", the succeeding AC component coefficient data AC13 is "0", and the succeeding AC component coefficient data AC23 is "1". However, AC component coefficient data provided before the AC component coefficient data AC22 is AC31. The value of the AC component coefficient data AC31 is "0 run 0 and value 1". Therefore, a table corresponding to this condition series is selected from a plurality of tables. Then, a variable length code 11 is assigned to the value "0" of the AC component coefficient data AC22, the value "0" of the AC component coefficient data AC13 and the value "1" of the AC component coefficient data AC23 on the basis of the selected table.

Then, the AC component coefficient data AC32 is "1" and AC component coefficient data provided before the AC component coefficient data AC32 are AC22, AC13 and AC23. The values thereof are "0 run 0 and value 1". Therefore, a table corresponding to this condition series is selected from a plurality of tables. Then, a variable length code 12 is assigned to the value "1" of the AC component coefficient data AC32 on the basis of the selected table.

Then, the AC component coefficient data AC33 is "1" and AC component coefficient data provided before the AC component coefficient data AC33 is AC32. The value thereof is "0 run 0 and value 1". Therefore, a table corresponding to this condition series is selected from a plurality of tables. Then, a variable length code 13 is assigned to the value "1" of the AC component coefficient data AC33 on the basis of the selected table.

The encoder that encodes the coefficient data has been described so far. Next, the decoder in the high-efficiency coding apparatus of the present embodiment will be described with reference to FIG. 4B.

As shown in FIG. 4B, there is provided an input terminal 6 to which there is supplied transmitted, reproduced or read-out data from a transmission line or output side of an electronic equipment (not shown). Various encoded data from this input terminal 6 are supplied to a variable length code decoder 7. The variable length code decoder 7 decodes the variable length code data supplied thereto through the input terminal 6 to provide quantized coefficient data, and supplies the quantized coefficient data to a quantization decoder 8.

The quantization decoder 8 decodes the coefficient data from the variable length decoder 7 to provide coefficient data that is not quantized, and supplies the resultant coefficient data to an inverse transform circuit 9. The inverse transform circuit 9 might be a circuit which carries out inverse transform of the discrete cosine transform, the Hadamard transform or the like that was already described in connection with the transform circuit 2. The original data thus obtained by the inverse transform is supplied through an output terminal 10 to a reproducing system or the like of an electronic equipment that includes this high-efficiency coding apparatus.

When the variable length code data is decoded by the variable length code decoder 7, or variable length code data is coded by using "0 run, value" as the condition series, the coding table that is used in the coding should be used as it is or the variable length code decoder 7 should include a table (coefficient data are respectively made corresponding to coded data) that is used to obtain the original coefficient data from the coded data.

As described above, according to this embodiment, the Huffman table generating apparatus is used, the table is formed by detecting the occurrence frequency of the coefficient data quantized by the quantizer 13, the coefficient data is coded by the Huffman coder circuit 14 on the basis of the table thus generated, and a quantization coarseness of the quantizer 13 is controlled by supplying the total code length data provided at that time to the quantizer 13. Then, a number of tables based on the condition series (0 run, value) are formed by repeating a series of the above-mentioned operation. The tables thus made are loaded onto the memory 4a of the variable length coder 4 in the encoder of the high-efficiency coding apparatus. When the coefficient data are coded by the high-efficiency coding apparatus, a table corresponding to the condition series of the coefficient data provided before that coefficient data is selected and the coefficient data are coded on the basis of the selected table. Thus, the total code length can be suppressed to be short.

While a plurality of tables based on the condition series generated by the Huffman table generating apparatus shown in FIGS. 4A, 4B or FIG. 5 are written in or loaded onto the memory 4a of the variable length coder 4 in the high-efficiency coding apparatus shown in FIG. 6 as described above, circuits connected to the next stage of the quantizer 13 shown in FIGS. 4A, 4B and FIG. 5, i.e., in the case of FIGS. 4A, 4B, the Huffman coder 4, the occurrence frequency detector 5 and the memory 6, in the case of FIG. 5, the Huffman coder 4, the occurrence frequency detector 5, the memory 6, the controller 7 and the switch 8 may be incorporated within the variable length coder 4. In that case, the memory 6 shown in FIGS. 4A, 4B or FIG. 5 can be served also as the memory 4a shown in FIG. 6.

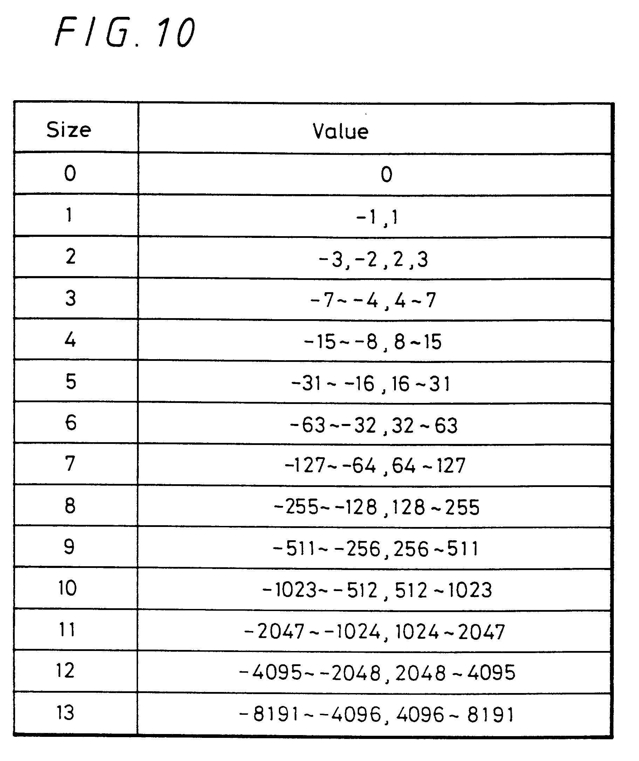

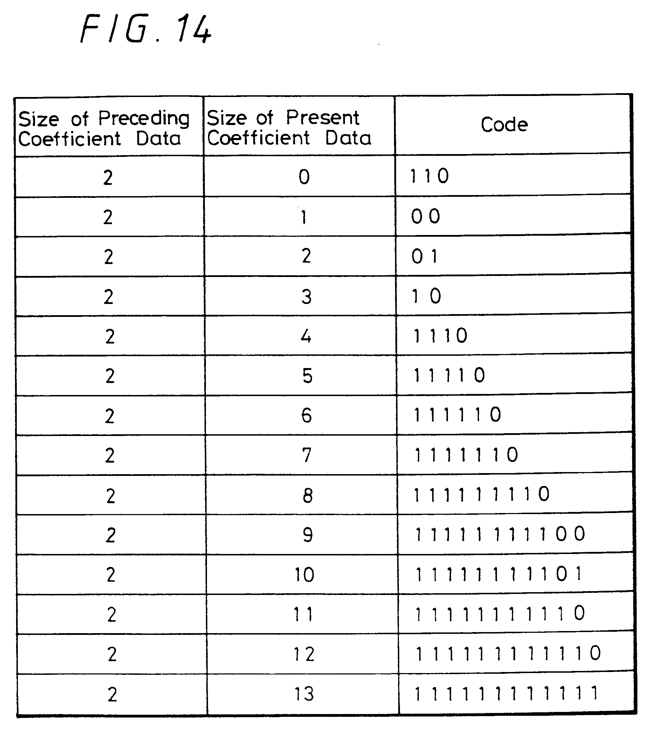

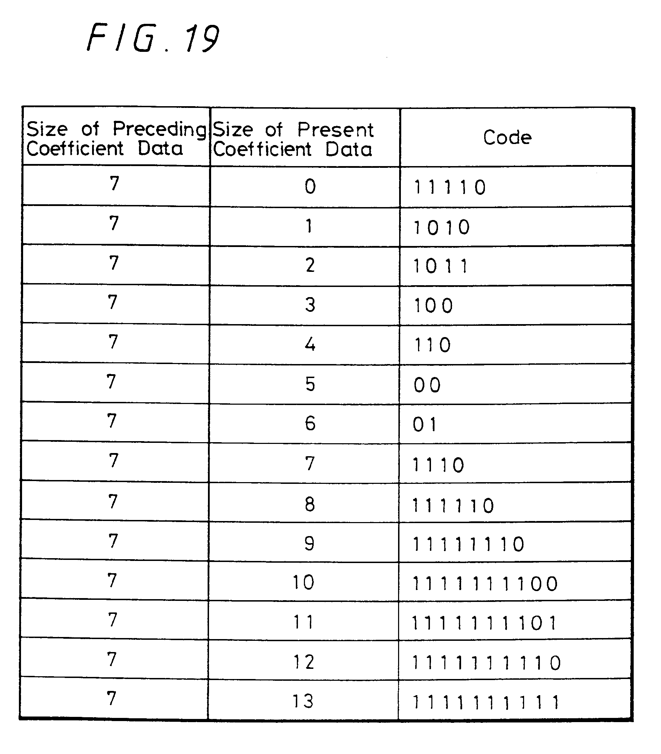

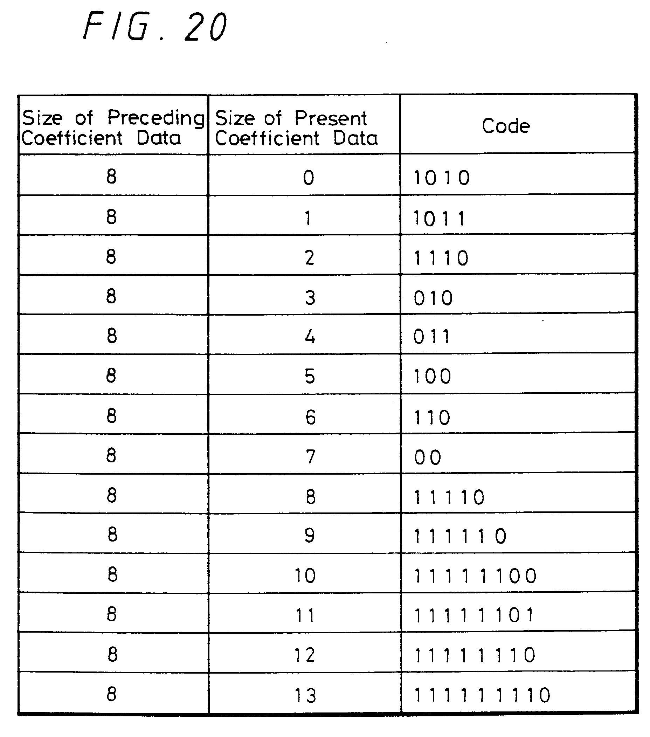

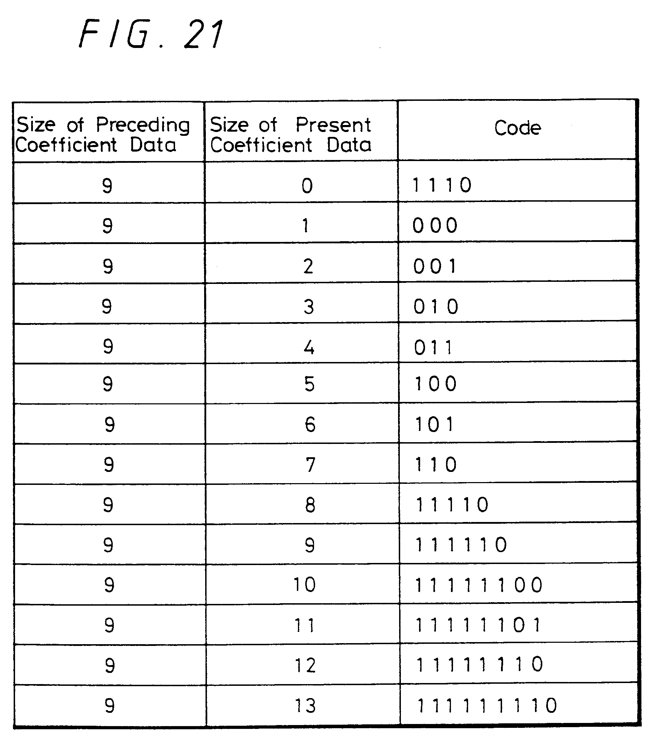

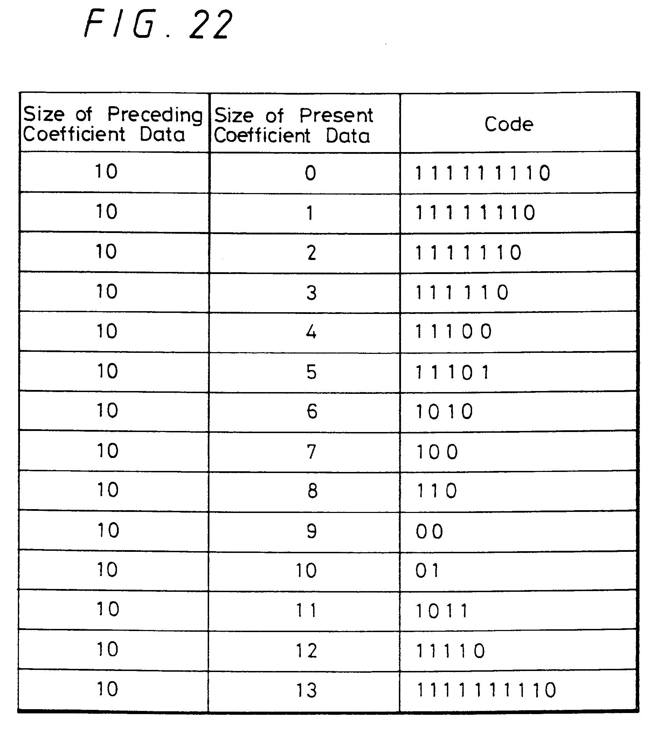

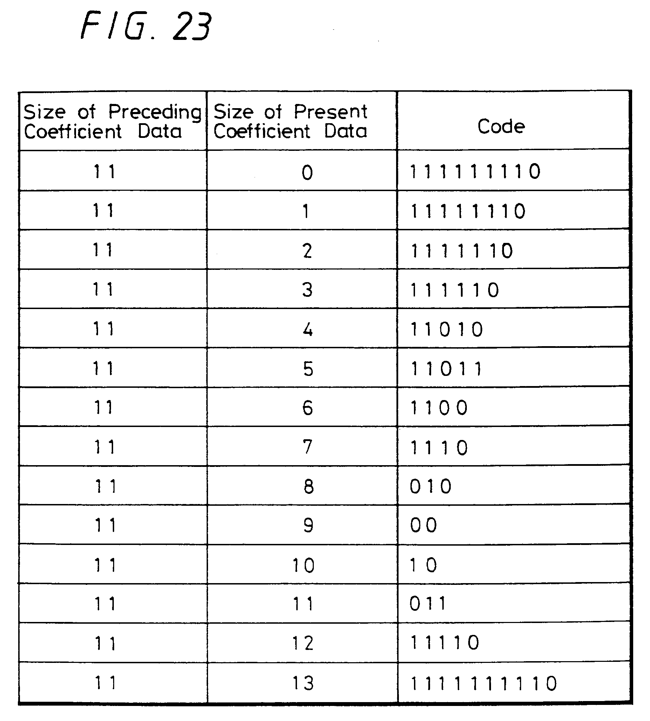

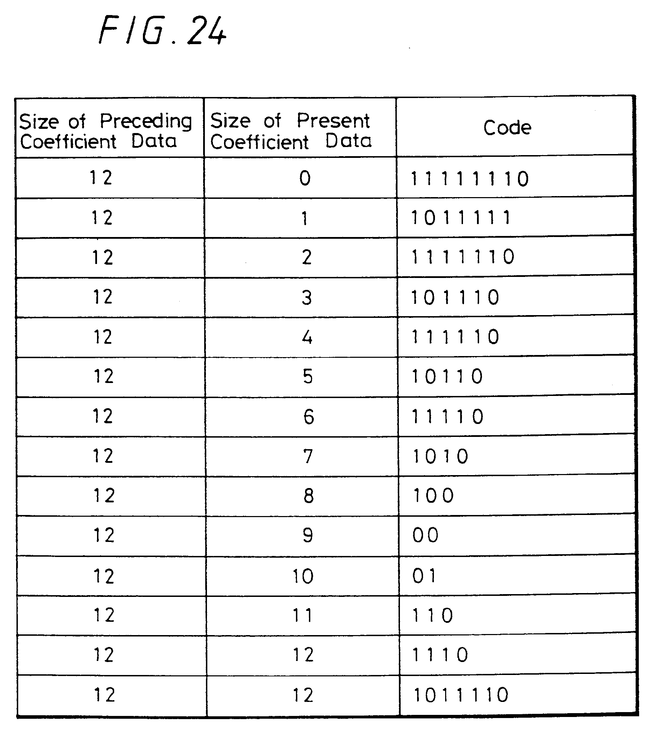

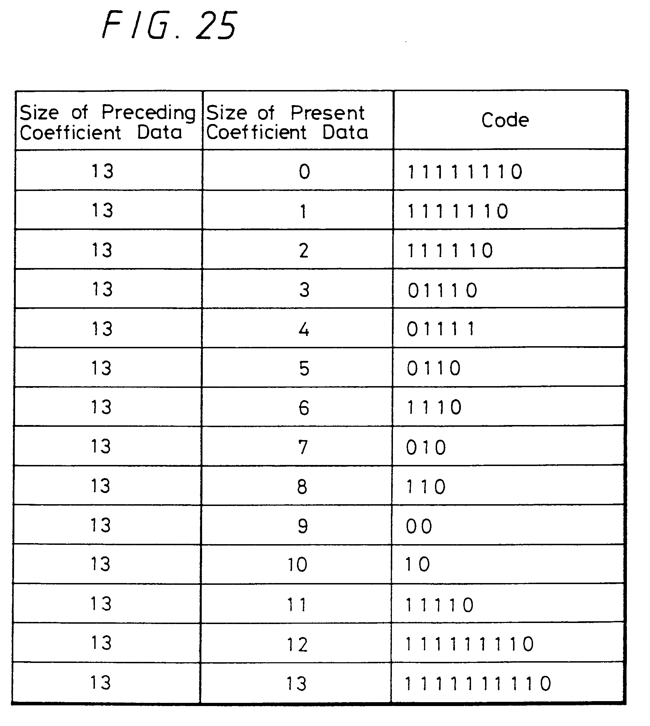

The coding using other condition series (sizes) than the above-mentioned condition series "0 run, value" will be described with reference to FIGS. 10 to 26. The "size" becomes a value of power obtained when the value of coefficient data is expressed by 2's power. The "size" is used as an index obtained when coefficient data are classified depending on the values thereof. However, 2 to the nine power makes 256 and a maximum value obtained when 256 is expressed by 9 bits becomes 255. Accordingly, when coefficient data are classified by "size" in actual practice, coefficient data becomes power exponent + 1 obtained when the coefficient value is expressed by 2 to the power.

FIG. 10 shows an example in which coefficient data are classified on the basis of a concept called "size". -As shown in FIG. 10, a coefficient value "0" is classified as size 0 (0 to the power), a coefficient value "-1" and a coefficient value "1" are classified as size 1 (1 to the power), ..., coefficient values "-1023 to -512" and coefficient values "512 to 1023" are classified as size 10 (10 to the power). Also, coefficient values "-8191 to -4096" and "4096 to 8191" are classified as size 13 (13 to the power).

In this embodiment, coefficient data of respective sizes are sequentially arranged in the order of small coefficient data from the left, for example, in FIG. 10. When coefficient data are classified, it is assumed that the Huffman coder 14 shown in FIGS. 5 and 6 has the table shown in FIG. 10. The sizes 0 to 13 shown on the table of FIG. 10 represent power exponents, respectively, and coefficient data of values that fall within this range are assigned to these sizes 0 to 13. When a value of coefficient data is "50", for example, this coefficient data value "50" falls within a range in which the power exponent is "6" from a size standpoint, i.e., "64". Accordingly, as shown in FIG. 10, the coefficient data of the value "50" becomes the size 6.

In this embodiment, values of coefficient data are classified at every size and many tables corresponding to the coefficient data sizes are prepared in advance. Then, when some coefficient data is coded, a table corresponding to the size of preceding coefficient data is selected and a Huffman code is assigned to coefficient data to be coded on the basis of the table thus selected. While the "0 run, value" is used as the condition series as described before, in this embodiment, the size is used as the condition series. Similarly, the table corresponding to the condition series of the preceding coefficient data is selected and the coding is carried out on the basis of the selected table.

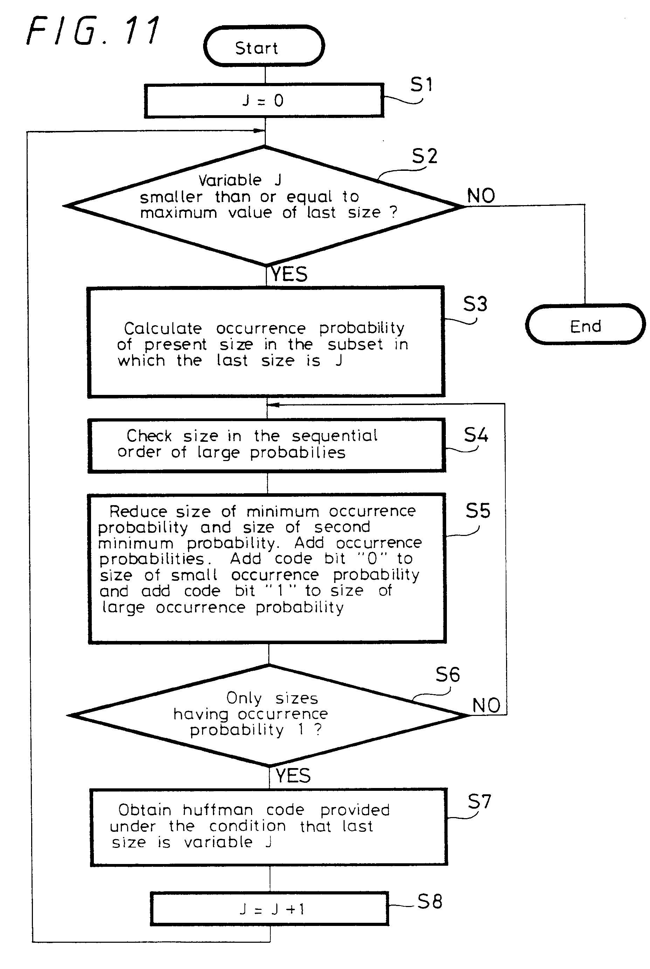

How to make tables corresponding to condition series (sizes of the preceding coefficient data) by using the Huffman table generating apparatus shown in FIGS. 5 and 6 will be described with reference to a flowchart forming FIG. 11.

As shown in FIG. 11, following the start of operation, "0" is substituted into a variable *J* which represents a value of size at step S1, and the processing proceeds to the next decision step S2. More specifically, the occurrence frequency detector 15 shown in FIGS. 5 and 6 sets "0" in the variable *J*.

It is determined in decision step S2 whether or not the variable *J* is smaller than or equal to the maximum value of the last size. If a YES is output at decision step S2, then the processing proceeds to step S3. If a NO is output at decision step S2, then this table making processing is ended. In this embodiment, "maximum value of last size" is the maximum value of the size used when a table is made before the processing of this time, and is not the maximum value of the size used in this processing.

In step S3, an occurrence probability of the present size in the subset in which the last size is *J* is calculated. Then, the processing proceeds to step S4.

In step S4, the sizes are sequentially checked in the order of large occurrence probabilities, and then the processing proceeds to the next step S5.

In step S5, the size of the minimum occurrence probability and the size of the second minimum occurrence probability are reduced and then replaced with new sizes. Then, occurrence probabilities thereof are added. A code bit "0" is added to the size of the small occurrence probability and a code bit "1" is added to the size of the large occurrence probability. Then, the processing proceeds to the next decision step S6.

It is determined in decision step S6 whether or not there are only sizes having an occurrence probability 1. If a YES is output at decision step S6, then the processing proceeds to step S7. If a NO is output at decision step S6, then the processing returns to step S4.

In step S7, a Huffman code provided under the condition such that the last size is the variable *J* is obtained. Then, the processing proceeds to step S8.

In step S8, 1 is added to the variable *J*, and then the processing returns to step S2.

Referring back to FIG. 7, the coding that is carried out when the condition series is the size will be described below. In the following description, only the coefficient data shown in FIG. 7 are referred to and "code 1" to "code 13", arrows which associate the coefficient data with the "code 1" to "code 13" and up brackets of respective coefficient data are not referred to.

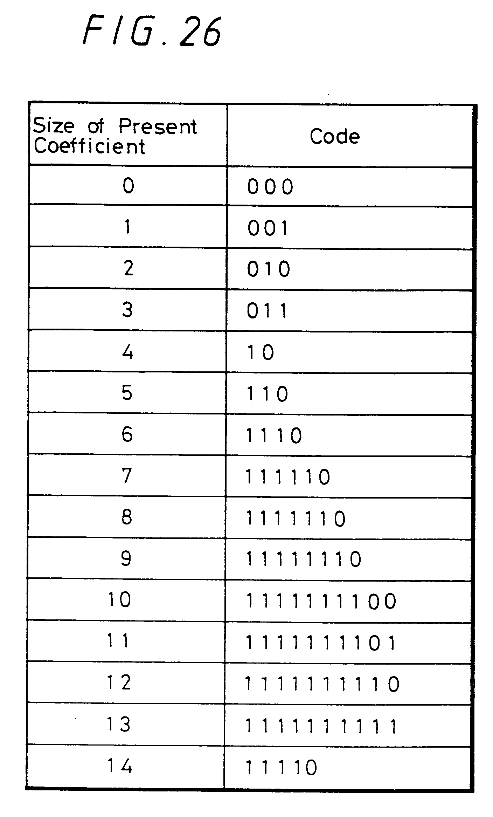

The coefficient data AC01 provided at the beginning of the AC component is "120" and the size thereof becomes "7" as can be understood from the table shown in FIG. 7. As earlier described in the example in which "0 run, value" is used as the condition series, the coefficient data AC01 is provided at the beginning of the AC component. Therefore, as shown in FIG. 26, variable length codes are assigned to the coefficient data at the leading portion on the basis of a table formed of sizes of present coefficient data and variable length codes assigned in accordance with the above sizes. As shown in FIG. 26, this table is a table formed of sizes of present coefficient data and variable length codes assigned in accordance with the sizes. That is, this table is used to obtain variable length codes from the coefficient data provided on the leading portion of the AC component as shown in FIG. 26.

More specifically, since the coefficient AC01 provided at the leading portion of this AC component is "120", the size "7" is obtained from the table shown in FIG. 10. Also, since the coefficient AC01 is provided at the leading portion of the AC component, the variable length code "111110" corresponding to the size "7" of the present coefficient data is obtained. Then, date representing the sequential order of "120" in the table shown in FIG. 10 is added to this code.

Data representing the sequential order of values are counted from 0th data as in the order of 0th data, 1st data, 2nd data, ... A bit length representing the sequential order of data is expressed by the bit length which is the same as the value of the size. In the case of the coefficient data corresponding to the size "7", for example, a bit length of data representing the sequential order of the size "7" becomes 7 bits. Since the sequential order of coefficient data is counted from "0", data representing the sequential order of all coefficient data in the range of size can be expressed by the bit length of numerical values represented by the sizes.

Data representing the sequential order of values will be described in practice. As shown in FIG. 10, the size of the value "120" of the coefficient data AC01 is "7" and 0th value of the size "7" is "-127". Therefore, "120" is counted in the sequential order of -127, -126, ... -64, 64, 65, ..., 120. In this case, "120" becomes 120th value, i.e., "1111000" and thus the coded output of the value "120" of the coefficient data AC01 becomes "1111110 1111000".

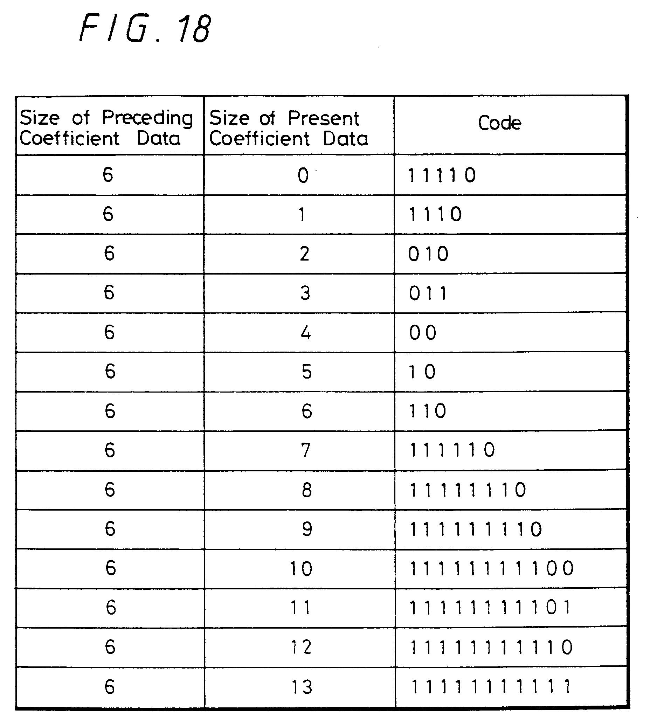

Subsequently, AC component coefficient data AC10 is "50" and the size thereof is "6" from the table shown in FIG. 10. However, the size of the AC component coefficient data AC01 provided just before the AC component coefficient data AC10 is "7". Therefore, a table representing the size "7" of the preceding AC component coefficient data as shown in FIG. 18 is selected and a variable length code "01" corresponding to the size "6" of the present coefficient data on the table shown in FIG. 18 is assigned to the coefficient data. Then, data representing the sequential order of value "50" on the table shown in FIG. 10 is added to this code. The size of the value "50" is "6" and the 0th value of the size "6" is "-63" and the value "50" is counted in the sequential order of -63, -62, ..., -32, 32, 33, ... 63. Thus, in this case, the code becomes 50th value.

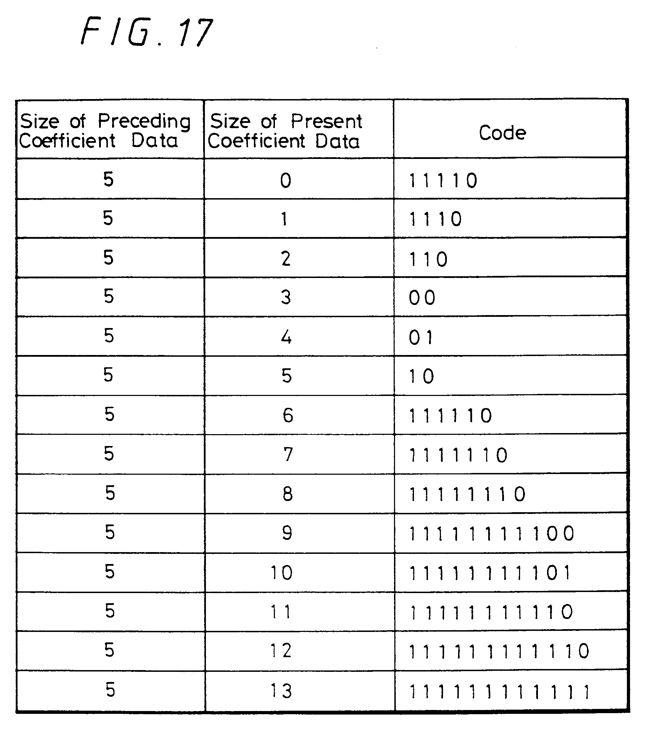

The next AC component coefficient data AC20 is "10" and the size thereof is "4" from the table shown in FIG. 10. The size of the AC coefficient data AC10 provided just before the AC component coefficient data AC20 is "6". Therefore, a table of the size "6" of the preceding coefficient data as shown in FIG. 17 is selected and a variable length code "00" corresponding to the size "4" of the present coefficient data on the table shown in FIG. 17 is assigned to the coefficient data. Then, data representing the sequential order of the value "10" on the table shown in FIG. 10 is added to this code. The size of the value "10" is "4" and 0th value of the size "4" is "-15". Thus, the value "10" is counted in the sequential order of -15, -14, ..., -8, 8, 9, ..., 15. Thus, in this case, the code becomes 10th value.

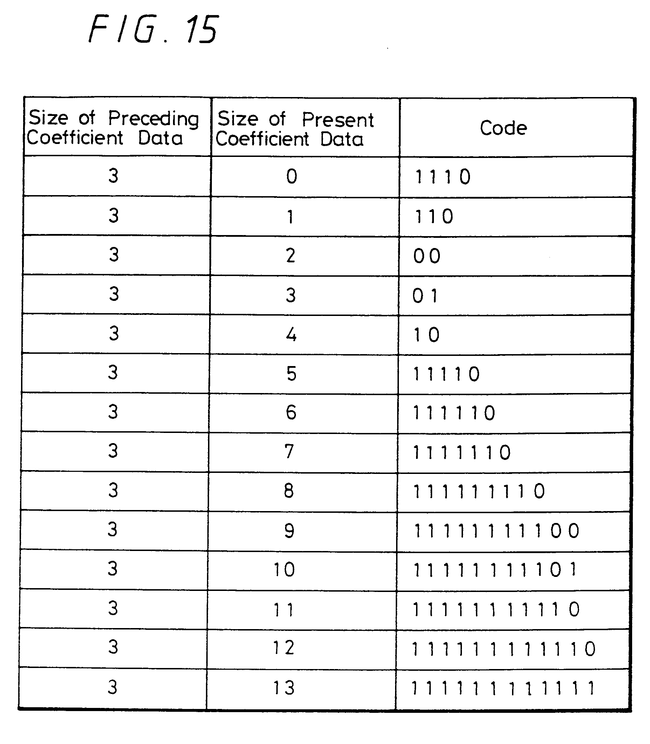

The next AC component coefficient data AC11 is "20" and the size thereof is "5" from the table shown in FIG. 10. The size of the AC component coefficient data AC20 provided just before the AC component coefficient data AC11 is "4". Therefore, a table of the size "4" of the preceding AC component coefficient data as shown in FIG. 15 is selected and a variable length code "110" corresponding to the size "5" of the present coefficient data on the table shown in FIG. 15 is assigned to the coefficient data. Then, data representing the sequential order of the value "20" on the table shown in FIG. 10 is added to this code. The size of the value "20" is "5" and 0th value of the size "5" is "-31". Thus, the value "20" is counted in the sequential order of -31, -30, ..., -16, 16, 17, ..., 31. Thus, in this case, the value becomes 20th value.

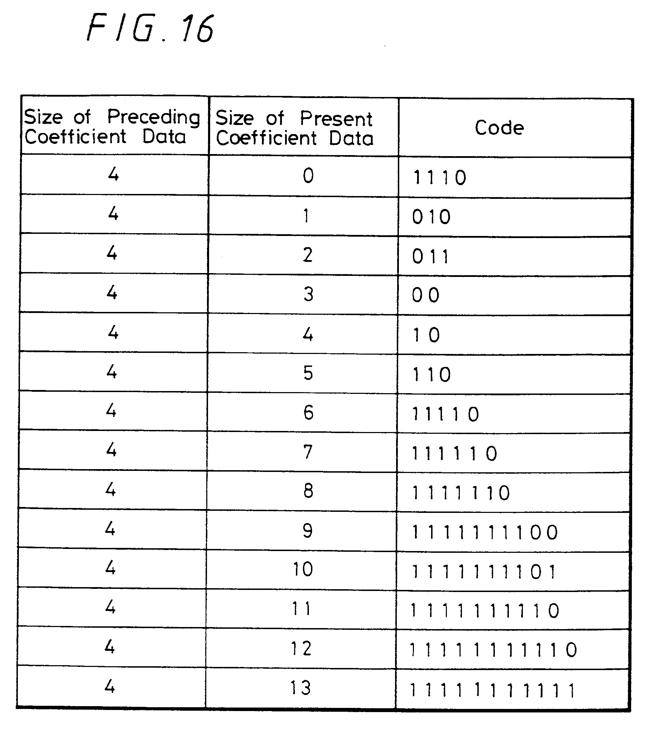

The next AC component coefficient data AC02 is "30" and the size thereof is "5" from the table shown in FIG. 10. The size of the AC component coefficient data AC11 provided just before the AC component coefficient data AC02 is "5". Therefore, a table of the size "5" of the preceding AC component coefficient data as shown in FIG. 16 is selected and a variable length code "10" corresponding to the size "5" of the AC component coefficient data on the table shown in FIG. 16 is assigned to the coefficient data. Thus, data representing the sequential order of the value "30" on the table shown in FIG. 10 is added to this code. The size of the value "30" is "5" and the 0th value of the size "5" is "-31". Thus, the value "30" is counted in the sequential order of -31, -30, ..., -16, 16, 17, ..., 31. Thus, in this case, the value becomes 30th value.

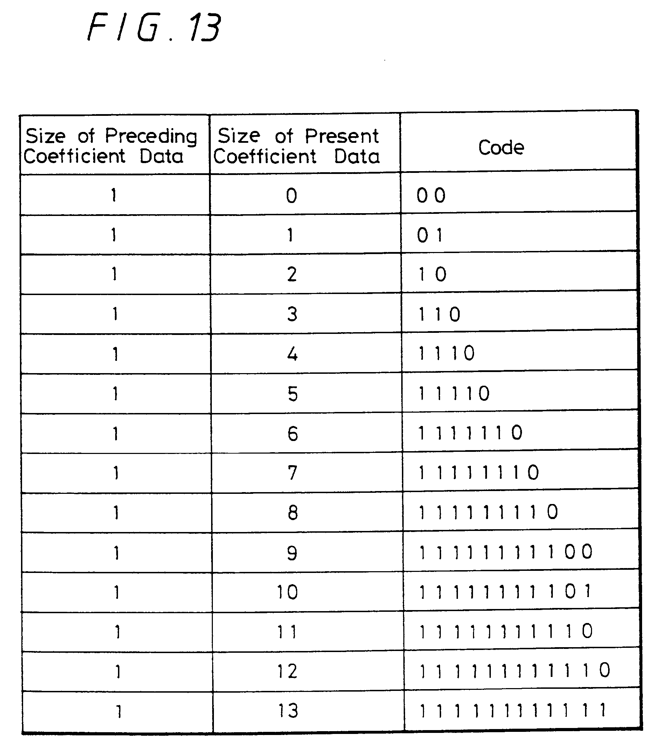

The next AC component coefficient data AC03 is "41" and the size thereof is "6" from the table shown in FIG. 10. The size of the AC component coefficient data AC02 provided just before the AC component coefficient data AC03 is "5". Therefore, a table of the size "5" of the preceding AC component coefficient data as shown in FIG. 16 is selected, and a variable length code "111110" corresponding to the size "6" of the present coefficient data on the table shown in FIG. 13 is assigned to the coefficient data. Thus, data representing the sequential order of the value "41" on the table shown in FIG. 10 is added to this code. The size of the value "41" is "6" and the 0th value of the size "6" is "-63". Thus, the value "63" is counted in the sequential order of -63, -62, ..., -32, 32, 33, ..., 63. Thus, in this case, the value becomes 41th value.

The next AC component coefficient data AC12 is "10" and the size thereof is "4" from the table shown in FIG. 10. The size of the AC component coefficient data AC03 provided just before the AC component coefficient data AC12 is "6". Therefore, a table of the size "6" of the preceding AC component coefficient data as shown in FIG. 17 is selected and a variable length code "00" corresponding to the size "4" of the present AC component coefficient data on the table shown in FIG. 17 is assigned to the coefficient data. Thus, data representing the sequential order of the value "10" on the table shown in FIG. 10 is added to the code. The size of the value "10" is "4" and 0th value of the size "4" is "-15". Thus, the value "10" is counted in the sequential order of -15, -14, ..., -8, 8, 9, ..., 15. Thus, in this case, the value becomes 10th value.

The next AC component coefficient data AC21 is "10" and the size thereof is "4" from the table shown in FIG. 10. The size of the AC component coefficient data AC12 provided before the AC component coefficient data AC21 is "4". Therefore, a table of the size "4" of the preceding AC component coefficient data as shown in FIG. 15 is selected, and a variable length code "10" corresponding to the size "4" of the present AC component coefficient data on the table shown in FIG. 15 is assigned to the coefficient data. Thus, data representing the sequential order of the value "10" on the table shown in FIG. 10 is added to the code. Also in this case, the value becomes 10th value similarly as described above.

Then, the AC component coefficient data AC30 is "3" and the size thereof is "2" from the table shown in FIG. 10. The size of the AC component coefficient data AC21 provided before the AC component coefficient data AC30 is "4". Therefore, a table of the size "4" of the preceding coefficient data shown in FIG. 15 is selected, and a variable length code "011" corresponding to the size "2" of the present AC component coefficient data on the table shown in FIG. 15 is assigned to the coefficient data. Thus, data representing the sequential order of the value "3" on the table shown in FIG. 10 is added to the code. The size of the value "3" is "2" and the 0th value of the size "2" is "-3". The value "3" is counted in the sequential order of -3, -2, 2, 3. In this case, the value becomes the 3rd value.

Then, the AC component coefficient data AC31 is "1" and the size thereof is "1" from the table shown in FIG. 10. The size of the AC component coefficient data AC30 provided just before the AC component coefficient data AC31 is "2". Therefore, a table of the size "2" of the preceding AC component coefficient data as shown in FIG. 13 is selected, and a variable length code "00" corresponding to the size "1" of the present AC component coefficient data on the table shown in FIG. 13 is assigned to the coefficient data. Thus, data representing the sequential order of the size "1" on the table shown in FIG. 10 is added to the code. The size of the value "1" is "1" and the 0th value of the size "1" is "-1". The value "1" is counted in the sequential order of -1, 1. Thus, the value becomes 1st value. When the value becomes the 1st value, data representing the sequential order of value need not be added to the code.

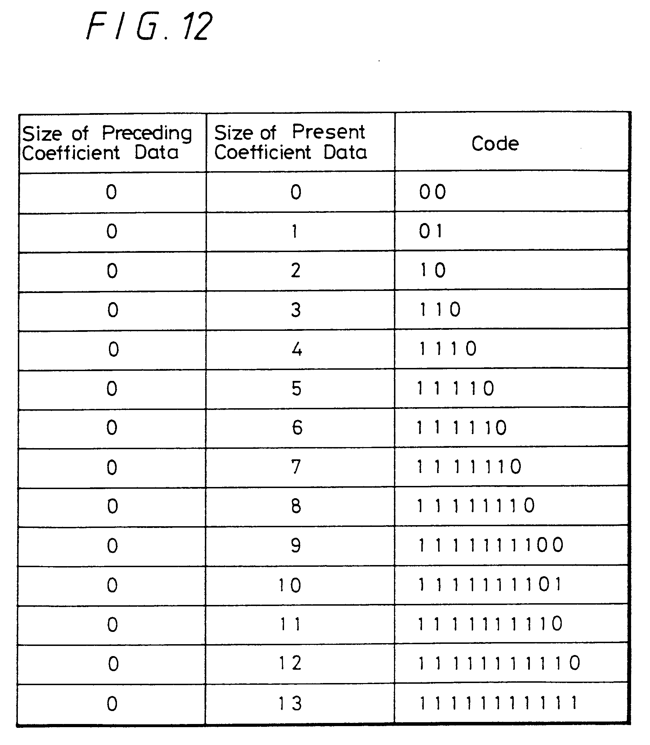

Then, the AC component coefficient data AC22 is "0" and the size thereof is "0" from the table shown in FIG. 10. The size of the AC component coefficient data AC31 provided just before the AC component coefficient data AC22 is "1". Therefore, a table of the size "1" of the preceding AC component coefficient data as shown in FIG. 12 is selected, and a variable length code "00" corresponding to the size "0" of the present AC component coefficient data on the table shown in FIG. 12 is assigned to the coefficient data. In this case, data representing the sequential order of the value "0" is not added to the code because the size "0" is combined with only "0" and data representing the sequential order of the value itself is useless.

Then, the AC component coefficient data AC13 is "0" and the size thereof is "0" from the table shown in FIG. 10. The size of the AC component coefficient data AC22 provided just before the AC component coefficient data AC13 is "0". Therefore, a table of the size "0" of the preceding AC component coefficient data shown in FIG. 11 is selected, and a variable code "00" corresponding to the size "0" of the present AC component coefficient data on the table shown in FIG. 11 is assigned to the coefficient data. Similarly as described above, data representing the sequential order of the value "0" is not added to the code.

Subsequently, the AC component coefficient data is "1" and the size thereof is "1" from the table shown in FIG. 10. The size of the AC component coefficient data AC13 provided just before the AC component coefficient data AC23 is "0". Therefore, a table of the size "0" of the preceding AC component coefficient data as shown in FIG. 11 is selected, and a variable length code "01" corresponding to the size "1" of the present AC component coefficient data on the table shown in FIG. 11 is assigned to the coefficient data. Data representing the sequential order of the value "1" on the table shown in FIG. 10 is added to the code. The size of the value "1" is "1" and the 0th value of the size "1" is "-1". The value "1" is counted in the sequential order of -1, 1. In this case, the value becomes the 1st value. When the value becomes the 1st value, data representing the sequential order of the value need not be added to the code.

Then, the AC component coefficient data AC32 is "1" and the size thereof is "1" from the table shown in FIG. 10. The size of the AC component coefficient data AC23 provided just before the AC component coefficient data AC32 is "1". Therefore, a table of the size "1" of the preceding AC component coefficient data as shown in FIG. 12 is selected, and a variable length code "01" corresponding to the size "1" of the present coefficient on the table shown in FIG. 12 is assigned to the coefficient data. Then, data representing the sequential order of the value "1" on the table shown in FIG. 10 is added to the code. Data representing the sequential order of the value becomes "1" similarly as described above.

Then, the AC component coefficient data AC33 is "1" and the size thereof is "1" from the table shown in FIG. 10. The size of the AC component coefficient data AC32 provided just before the AC component coefficient data AC33 is "1". Therefore, a table of the size "1" of the preceding AC component coefficient data as shown in FIG. 12 is selected, and a variable length code "01" corresponding to the size "1" of the present coefficient data on the table shown in FIG. 12 is assigned to the coefficient data. Then, data representing the sequential order of the value "1" on the table shown in FIG. 10 is added to the code. Data representing the sequential order of the value becomes "1" similarly as described above.

On the other hand, when the variable length code data is decoded by the variable length code decoder 17, or when the condition series is used as the size, the table is selected on the basis of the preceding AC component coefficient data and the encoded code data is decoded on the basis of the selected table, as already described, data representing the sequential order of the value of the coefficient data on the table shown in FIG. 10 is added to the code data. Therefore, the table shown in FIG. 10 and the tables shown in FIGS. 11 through 26 may be used as they are. Alternatively, new tables may be formed by compressing these many tables so that these tables are exclusively used in decoding, and the new tables thus formed may be used.

According to the coding method of the present embodiment, since data representing the sequential order of the values of the coefficient data on the table shown in FIG. 10 are added to the code data, the variable length code decoder 17 can easily decode the code data on the basis of the tables shown in FIGS. 10 through 26 or by using the new tables which results from compressing the above-mentioned tables. Also, since the data representing the sequential order of the values of the coefficient data on the table shown in FIG. 10 are added to the code data so that, even when the codes are the same, it is possible to obtain with ease coefficient data of that code by detecting the data representing the sequential order of the value of the coefficient data added to the code.

As described above, according to the embodiment of the present invention, the table in which the size is used as the condition series is formed by detecting the frequency at which the coefficient data quantized by the quantizer 13 occurs, The Huffman coder 14 codes data on the basis of the table thus formed and the quantization coarseness of the quantizer 13 is controlled by supplying the total code length data to the quantizer 13. Then, a number of tables based on the condition series are formed by repeatedly carrying out the above-mentioned operation. The many tables thus formed are loaded onto the memory 4a of the variable length coder 4 of the encoder in the high-efficiency coding apparatus. Thus, when coefficient data is coded by the high-efficiency coding apparatus, the table corresponding to the size of the coefficient data provided just before the coefficient data is selected and data is coded on the basis of the table thus selected. Therefore, the total code length can bs suppressed to be short. Further, according to the embodiment of the present invention, since the data representing the sequential order of the size of the coefficient data on the size table is added to the coded coefficient data, the coded data can be decoded by the simple arrangement and by the simple processing.

Having described preferred embodiments of the invention with reference to the accompanying drawings, it is to be understood that the invention is not limited to those precise embodiments and that various changes and modifications could be effected therein by one skilled in the art without departing from the scope of the invention as defined in the appended claims.

## Claims

1. A method of coding a digital signal comprising the steps of:
step (a) for convening a digital signal into a data series formed of consecutive zero coefficients and non-zero coefficients;
step (b) for classifying each of said non-zero coefficients into one of a plurality of size groups in response to the value of said non-zero coefficient;
step (c) for dividing said data series into a plurality of events, each event comprising either a single non-zero coefficient or a run of zero coefficients having a run length and accompanied by a non-zero coefficient immediately preceding or succeeding said run of zero coefficients; and
step (d) for determining a code word for each of said events using data from one of a plurality of tables, the table being used for each event being selected in dependence upon the size group of the non-zero coefficient of the preceding event.

2. A method of coding a digital signal according to claim 1 wherein said code word includes order information representing a sequential order position within its size group of the non-zero coefficient of said event.

3. A method of coding a digital signal as claimed in claim 1, wherein said plurality of tables are generated by the steps of:
step (a) for converting a predetermined digital signal into a data series formed of consecutive zero coefficients and non-zero coefficients;
step (b) for dividing said data series into a plurality of events, each event comprising either a single non-zero value or a run of zero coefficients having a run length and accompanied by a non-zero coefficient immediately preceding or succeeding said run of zero coefficients;
step (c) for classifying each of said non-zero coefficients into one of a plurality of size groups in response to the value of said non-zero coefficient;
step (d) for detecting an occurrence frequency at which a next event occurs; and
step (e) for generating table data, for use when events within a desired data series are to be coded in response to the size group of immediately preceding events within said data series, in response to the detected occurrence frequency of said events and storing the same in a memory.

4. A coding apparatus comprising:
convening means for convening a digital signal into a data series formed of consecutive zero coefficients and non-zero coefficients;
classifying means for classifying each of said non-zero coefficients into one of a plurality of size groups in response to the value of said non-zero coefficient;
memory means (4a) for storing therein a plurality of tables, each table containing table data representing code words for coding a plurality of events, each event comprising either a single non-zero value or a run of zero coefficients having a run length and accompanied a non-zero coefficient immediately preceding or succeeding said run of zero coefficients; and
coding means (4) for dividing said data series into a plurality of events and assigning a code word to each of said plurality of events on the basis of table data from one of said plurality of tables selected in dependence upon the size group of the non-zero coefficient of an immediately preceding event.

## Patentansprüche

1. Verfahren zum Codieren eines digitalen Signals, umfassend die Schritte:
Schritt (a) zur Umsetzung eines digitalen Signals in eine Datenfolge, die aus aufeinanderfolgenden Null-Koeffizienten und Nicht-Null-Koeffizienten gebildet ist,
Schritt (b) zur Klassifizierung jedes der Nicht-Null-Koeffizienten in eine Gruppe von einer Vielzahl von Größen-Gruppen in Abhängigkeit vom Wert des betreffenden Nicht-Null-Koeffizienten,
Schritt (c) zur Aufteilung der genannten Datenfolge in eine Vielzahl von Ereignissen, deren jedes entweder einen einzelnen Nicht-Null-Koeffizienten oder eine Reihe von Null-Koeffizienten mit einer Reihen- bzw. Lauflänge aufweist und begleitet ist von einem Nicht-Null-Koeffizienten unmittelbar vor oder nach der betreffenden Reihe der Null-Koeffizienten, und
Schritt (d) zur Bestimmung eines Codewortes für jedes der genannten Ereignisse unter Heranziehung von Daten aus einer Tabelle von einer Vielzahl von Tabellen, wobei die für das jeweilige Ereignis benutzte Tabelle in Abhängigkeit von der Größen-Gruppe des Nicht-Null-Koeffizienten des vorangehenden Ereignisses ausgewählt ist.

2. Verfahren zum Codieren eines digitalen Signals nach Anspruch 1, wobei das genannte Codewort eine Reihenfolgeinformation enthält, die eine sequentielle Rang- bzw. Reihenfolgeposition innerhalb ihrer Größen-Gruppe des Nicht-Null-Koeffizienten des genannten Ereignisses repräsentiert.

3. Verfahren zum Codieren eines digitalen Signals nach Anspruch 1, wobei die genannte Vielzahl der Tabellen durch die Schritte erzeugt wird:
Schritt (a) zur Umsetzung eines bestimmten digitalen Signals in eine Datenfolge, die aus aufeinanderfolgenden Null-Koeffizienten und Nicht-Null-Koeffizienten gebildet ist,
Schritt (b) zur Aufteilung der genannten Datenfolge in eine Vielzahl von Ereignissen, deren jedes entweder einen einzelnen Nicht-Null-wert oder eine Reihe von Null-Koeffizienten mit einer Reihen- bzw. Lauflänge aufweist und begleitet ist von einem Nicht-Null-Koeffizienten unmittelbar vor oder nach der betreffenden Reihe von Null-Koeffizienten,
Schritt (c) zur Klassifizierung jedes der genannten Nicht-Null-Koeffizienten in eine Gruppe aus einer Vielzahl von Größen-Gruppen in Abhängigkeit vom Wert des genannten Nicht-Null-Koeffizienten,
Schritt (d) zur Ermittlung einer Auftrittshäufigkeit, mit der ein nächstes Ereignis auftritt, und
Schritt (e) zur Erzeugung von Tabellendaten für die Verwendung in dem Fall, dass Ereignisse innerhalb einer gewünschten Datenfolge in Abhängigkeit von der Größen-Gruppe von unmittelbar vorhergehenden Ereignissen innerhalb der genannten Datenfolge zu codieren sind, auf die ermittelte Auftrittshäufigkeit der genannten Ereignisse hin und zur Speicherung derselben in einem Speicher.

4. Codiervorrichtung, umfassend:
eine Umsetzeinrichtung zur Konvertierung eines digitalen Signals in eine Datenfolge, die aus aufeinanderfolgenden Null-Koeffizienten und Nicht-Null-Koeffizienten gebildet ist,
eine Klassifizierungseinrichtung zur Klassifizierung jeder der genannten Nicht-Null-Koeffizienten in eine Gruppe von einer Vielzahl von Größen-Gruppen in Abhängigkeit vom Wert des genannten Nicht-Null-Koeffizienten,
eine Speichereinrichtung (4a) zur Speicherung einer Vielzahl von Tabellen, deren jede Tabellendaten enthält, die Codewörter zur Codierung einer Vielzahl von Ereignissen repräsentieren, wobei jedes Ereignis entweder einen einzelnen Nicht-Null-Wert oder eine Reihe von Null-Koeffizienten mit einer Reihen- bzw.
Lauflänge umfasst und begleitet ist von einem Nicht-Null-Koeffizienten unmittelbar vor oder nach der betreffenden Reihe von Null-Koeffizienten,
und eine Codiereinrichtung (4) zur Aufteilung der genannten Datenfolge in eine Vielzahl von Ereignissen und zur Zuordnung eines Codewortes zu jedem Ereignis der betreffenden Vielzahl von Ereignissen auf der Grundlage von Tabellendaten aus einer Tabelle der genannten Vielzahl von Tabellen, die ausgewählt ist in Abhängigkeit von der Größen-Gruppe des Nicht-Null-Koeffizienten eines unmittelbar vorhergehenden Ereignisses.

## Revendications

1. Procédé de codage d'un signal numérique comprenant les étapes suivantes :
une étape (a) destinée à convertir un signal numérique en une série de données formées de coefficients nuls consécutifs et de coefficients non nuls,
une étape (b) destinée à classer chacun desdits coefficients non nuls dans l'un d'une pluralité de groupes de taille en réponse à la valeur dudit coefficient non nul,
une étape (c) destinée à diviser ladite série de données en une pluralité d'événements, chaque événement comprenant soit un coefficient non nul unique, soit une suite de coefficients nuls présentant une longueur de suite et accompagnée d'un coefficient non nul précédent ou suivant immédiatement ladite suite de coefficients nuls, et
une étape (d) destinée à déterminer un mot de code pour chacun desdits événements en utilisant des données provenant de l'une d'une pluralité de tables, la table étant utilisée pour chaque événement qui est sélectionné suivant le groupe de taille du coefficient non nul de l'événement précédent.

2. Procédé de codage d'un signal numérique selon la revendication 1, dans lequel ledit mot de code comprend des informations d'ordre représentant une position d'ordre séquentiel à l'intérieur de son groupe de taille du coefficient non nul dudit événement.

3. Procédé de codage d'un signal numérique selon la revendication 1, dans lequel ladite pluralité de tables est générée par les étapes suivantes :
une étape (a) destinée à convenir un signal numérique prédéterminé en une série de données formée de coefficients nuls consécutifs et de coefficients non nuls,
une étape (b) destinée à diviser ladite série de données en une pluralité d'événements, chaque événement comprenant soit une valeur non nulle unique soit une suite de coefficients nuls présentant une longueur de suite et accompagnée d'un coefficient non nul précédent ou suivant immédiatement ladite suite de coefficients nuls,
une étape (c) destinée à classer chacun desdits coefficients non nuls dans l'un d'une pluralité de groupes de taille en réponse à la valeur dudit coefficient non nul,
une étape (d) destinée à détecter une fréquence d'occurrences à laquelle apparaît un événement suivant, et
une étape (e) destinée à générer des données de table, en vue d'une utilisation lorsque des événements à l'intérieur d'une série de données désirée doivent être codés en réponse au groupe de taille des événements immédiatement précédents à l'intérieur de ladite série de données, en réponse à la fréquence d'occurrences détectée desdits événements et mémoriser celles-ci dans une mémoire.

4. Dispositif de codage comprenant :
un moyen de conversion destiné à convertir un signal numérique en une série de données formée de coefficients nuls consécutifs et de coefficients non nuls,
un moyen de classification destiné à classer chacun desdits coefficients non nuls dans l'un d'une pluralité de groupes de taille en réponse à la valeur dudit coefficient non nul,
un moyen de mémoire (4a) destiné à mémoriser dans celle-ci une pluralité de tables, chaque table contenant des données de table représentant des mots de code en vue de coder une pluralité d'événements, chaque événement comprenant soit une valeur non nulle unique, soit une suite de coefficients nuls présentant une longueur de suite et accompagnée d'un coefficient non nul précédent ou suivant immédiatement ladite suite de coefficients nuls, et
un moyen de codage (4) destiné à diviser ladite série de données en une pluralité d'événements et à affecter un mot de code à chaque événement de ladite pluralité d'événements sur la base des données de table à partir de l'une de ladite pluralité de tables sélectionnée suivant le groupe de taille d'un coefficient non nul d'un événement immédiatement précédent.
